# EUROPEAN PATENT APPLICATION

(11) **EP 3 978 428 A1**
(43) Date of publication of application: **06.04.2022**
(21) Application number: 20199776.4
(22) Date of filing: 02.10.2020
(51) Int. Cl.: C01B 3/24, C09C 1/48, H01J 37/32, H05H 1/42, H05H 1/48

(54) **FACILITY COMPRISING A DEVICE FOR THE PRODUCTION OF HYDROGEN AND SOLID CARBON AND A POWER PLANT UNIT AND METHOD FOR OPERATING THE FACILITY**

(71) Applicant: Uniper Hydrogen GmbH, 40221 Düsseldorf (DE)
(72) Inventor: Markowz, Georg, 63755 Alzenau (DE)
(74) Representative: Ter Meer Steinmeister & Partner

(57) **Abstract**

The present invention relates to a facility comprising a power plant unit and at least one device for the production of hydrogen and solid carbon from a C₁- to C₄-alkane-containing gas by use of electric energy which includes a plasma reactor and a device for separating solid carbon from hydrogen, wherein the plasma reactor has a specific reactor geometry. Furthermore, the present invention relates to a method for operating the facility according to the invention.

## Description

The present invention relates to a facility comprising a power plant unit and at least one device for the production of hydrogen and solid carbon from a C₁- to C₄-alkane-containing gas by use of electric energy which includes a plasma reactor and a device for separating solid carbon from hydrogen, wherein the plasma reactor has a specific reactor geometry. Furthermore, the present invention relates to a method for operating the facility according to the invention.

There is an increasing demand for clean and storable energy sources which upon production and consumption have a reduced CO₂ footprint. However, such energy sources will only be accepted in the market, if they can also be produced at sufficiently low cost. This especially applies to energy sources intended for use in the sectors of mobility and heat production and in the chemical industry, steel industry and refinery industry.

Hydrogen has been investigated as a source of clean and storable energy for some time now. Hydrogen may be used for direct combustion, in fuel cells or for production of synthetic fuels, such as methanol, dimethyl ether, synthetic natural gas, synthetic gasoline, synthetic diesel or synthetic kerosene. In the production of synthetic fuels carbon dioxide (CO₂) may, for example, be selected as the carbon source.

Conventionally, hydrogen is produced from coal, liquid hydrocarbons or gaseous hydrocarbons by means of gasification or reforming reactions. These conversions typically take place at high temperatures and go along with considerable emissions of CO₂, originating from both, the reactions themselves and the generation of the heat needed to drive these reactions.

Approaches to reduce these emissions of CO₂ have been investigated and are currently under development. One of the known approaches includes the steps of capturing CO₂, which is generated in the conventional hydrogen production plants, and compressing and sequestering it subsequently. However, in cases in which the hydrogen production sites are far away from possible sequestration sites, costs for the logistics may be unreasonably high.

Another way to produce hydrogen is the use of an electrolysis cell which splits water into oxygen and hydrogen. The electrolysis itself does not produce any CO₂ emissions. Yet, high amounts of energy (high currents) are needed to drive the electrolysis. This can be evidenced by the standard molar enthalpy of the water splitting reaction in the following formula (1). In formula (1) and all following formulae the reaction the standard molar enthalpy is based on 298 K, if not specified otherwise.

2 H₂O → O₂ + 2H₂, ΔH = +241 kJ/mol (1)

Due to the large specific amount of electrical energy needed in the electrolysis, the overall CO₂ emissions are strongly related to the CO₂ emissions connected with the production of the consumed electricity. On the one hand, penetration of renewable power production is not yet sufficient at many places in the world and average CO₂ emissions from power production are, thus, too high to run electrolysis in an environmentally sustainable way. On the other hand, if electrolysis was only or predominantly operated on renewable electricity, the corresponding annual full load hours would be too low to enable economic operation.

The binding energy of hydrogen-carbon bonds in hydrocarbons, such as methane, is smaller than the binding energy of hydrogen-oxygen bonds in water. Accordingly, the splitting of hydrocarbons into hydrogen and carbon theoretically allows for a hydrogen production with an energy input that is reduced compared to the energy input in the electrolysis process.

Several technologies have already been investigated and developed to exploit the advantages of the smaller binding energy in hydrocarbons. WO 2013/004398 A2, for instance, describes a process for splitting of hydrocarbons in the presence of a moving bed containing carbon-rich granules. In one embodiment of the process, the heat which is needed to drive the splitting is provided by combustion of a fuel comprising a portion of the hydrogen that has been obtained by the hydrocarbon splitting. However, there is a need for improvement of this technology, since it requires quite high specific capital expenditure, especially at small scales.

Moreover, plasma-based partial hydrocarbon splitting processes are known from the acetylene (C₂H₂) production. Acetylene is a valuable compound as it can serve as feedstock for the manufacture of several chemicals. During the acetylene production, small amounts of hydrogen are formed as a by-product and remain in the target product acetylene (cf. formula (2), showing the methane conversion as an example of hydrocarbon conversion).

2 CH₄ ⇄ C₂H₂ + 3 H₂, ΔH = +376 kJ/mol (2)

One example of an acetylene production process is the so-called "Huels arc process". This process includes a one-step conversion of low molecular weight hydrocarbons, for example methane, to acetylene by means of an electric arc. This conversion is followed by extremely rapid cooling of the hydrocarbon-derived plasmaeous plasma gas, the so-called quenching step, to stabilize the highly reactive acetylene. Thereby, the formation of derivatives such as high molecular weight hydrocarbon compounds from acetylene is suppressed (cf. Acetylene, Paessler et al., Ullmann's Encyclopedia of Industrial Chemistry, 2011). In view of extensive hydrogen production, the benefit of this process may be limited by the need to find sufficient demand for acetylene. This may impede commercialization of this process for hydrogen production.

Another example of an acetylene production process is disclosed in WO 2015/140058 A1. There, methane-containing gas is converted to acetylene by means of an electric arc. Immediately afterwards, the acetylene-containing mixture is rapidly cooled (quenched) with further methane-containing gas to increase the yield of acetylene. Then, the acetylene is further mixed with another hydrocarbon-containing feedstock and maintained at lower temperatures to facilitate its reaction with the additional feedstock to one or more hydrogen- and carbon-containing products having a boiling point of at least 15 °C. The reactor described therein has three to four different sections of defined length. In each section, gaseous or liquid medium is introduced by at least one inlet for the respective medium. Thereby, the process of WO 2015/140058 A1 ensures the formation of the one or more hydrogen- and carbon-containing organic compounds having a boiling point of at least 15 °C.

Yet, the present inventor has found that neither the reactor nor the process described in WO 2015/140058 A1 allows for an energy efficient and cost-effective process for production of hydrogen and solid carbon from C₁- to C₄-alkane containing gas with high yields of hydrogen. Furthermore, this process is comparable to the Huels arc process in that it imposes the need to find applications for the chemicals produced in parallel to hydrogen which may render commercialization of the process complex and hence restrict its potential for hydrogen production.

One approach for plasma-based hydrogen and solid carbon production by hydrocarbon splitting is described in WO 93/12030 A1. This piece of prior art aims at reengineering known hydrocarbon pyrolysis processes in such a way that carbon particles of specific properties are obtained (for example specific particle size and morphology). To that end, the process utilizes a voluminous reactor which is equipped with concentrically arranged tubular electrodes. An electric arc is provided at those ends of the tubular electrodes which protrude into the reactor volume. This generates a plasmaeous plasma gas from hydrogen in a first step. In a second step the plasmaeous plasma gas is mixed with methane.

However, the present inventor found that such two-step processes for the hydrogen production requires an unfavorably high reactor volume and results in reactor zones with very different process conditions (for example different temperatures and gas compositions) which renders the processes overall inefficient and costly.

An alternative method of plasma-based hydrogen production from hydrocarbon splitting is described in WO 01/46067 A1. Key of this process is the use of a laval-type nozzle in the reactor. Similar to WO 2015/140058 A1, an electric arc is used to produce a plasmaeous plasma gas from hydrogen or inert gas. Methane is fed into the plasmaeous plasma gas to produce a gas mixture comprising acetylene. The gas mixture is then passed downstream through the nozzle. By a specific gas dynamic effect, the nozzle induces a relatively high pressure drop. Concomitantly, the mean temperature of the gas mixture is significantly decreased.

The thermal energy of the hot process gas upstream of the nozzle therefore remains largely unexploited. Furthermore, the process is disadvantageous due to the pressure drop. Most downstream processes or logistics of hydrogen are designed for higher pressures and would correspondingly require a recompression. Overall, the process is characterized by a very specific design requiring tuned process conditions and high specific energy expenses contrasting with the wish to provide an energy efficient process for the hydrogen and solid carbon production.

Summarizing, the abovementioned processes have limitations and do not allow for an economical, clean and environmentally friendly energy efficient hydrogen and solid carbon production. Moreover, they do not suggest an ecologically reasonable re-conversion of hydrogen to electricity. In particular, these processes have high investment and operation costs, and/or a low energy efficiency.

These drawbacks can be overcome by the facility according to the present invention.

The facility according to the present invention comprises a power plant unit, and at least one device for the production of hydrogen and solid carbon from a C₁- to C₄-alkane-containing gas by use of electric energy which includes a plasma reactor and a device for separating solid carbon from hydrogen, wherein the plasma reactor comprises
a plasma section comprising:
an anode and a cathode for generating an electric arc, the arc extending within the plasma section and at least one first feed line for introducing the C₁- to C₄-alkane-containing gas into the plasma section of the plasma reactor,
wherein the anode has a hollow channel along the flow direction of a main stream of the gas which has an inner surface, an outlet in the flow direction of the main stream of the gas which forms the open end of the anode in the flow direction of the main stream of the gas, and at least one inlet for receiving the C₁- to C₄-alkane-containing gas introduced into the plasma section of the reactor via the at least one first feed line wherein the inlet forms the open end of the anode facing into the direction opposite to the flow direction of the main stream of the gas, and wherein the anode is configured such that the gas flows through the hollow channel via the open end of the anode facing into the direction opposite to the flow direction of the main stream of the gas and the open end of the anode in the flow direction of the main stream of the gas, wherein the gas contacts the inner surface of the hollow channel of the anode on its passage through the anode, and
wherein said anode and said cathode are arranged so that the arc generated by them is formed in said plasma section to form a plasmaeous plasma gas in said plasma section from the C₁- to C₄-alkane-containing gas introduced into said plasma section through said at least one first feed line, and wherein the foot points of the electric arc contacting the anode are located on the inner surface of the hollow channel of the anode, and
a second reactor section directly downstream of the plasma section of the plasma reactor in the flow direction of the main stream of the gas, the second reactor section comprising
a first subsection and a second subsection, wherein the second subsection is directly downstream of the first subsection in the flow direction of the main stream of the gas, and
outlet means for withdrawing components from the reactor, wherein the out-let means are located at the end of the second reactor section in the flow direction of the main stream of the gas,
wherein the first subsection comprises at least one second feed line for introducing a C₁- to C₄-alkane-containing gas into the second reactor section, wherein the at least one second feed line is arranged such that the C₁- to C₄-alkane-containing gas which is introduced into the plasma reactor via the at least one second feed line is introduced into the plasmaeous plasma gas at a position downstream of the foot points of the electric arc in the flow direction of the main stream of the gas, so that in the first subsection of the second reactor section downstream of the at least one second feed line a mixture is formed from the plasmaeous plasma gas leaving the plasma section and the C₁- to C₄-alkane-containing gas of the at least one second feed line, and wherein the position of the at least one second feed line along the flow direction of the main stream of the gas defines the beginning of the second reactor section and of its first subsection, and
wherein the volume of the plasma section which begins at the most up-stream position at which the inner surface of the hollow channel of the anode is facing the electric arc and reaches down to the end of the plasma section of the plasma reactor has a volume in the range of 0.0001 m³ to 0.4m³ and defines a reference volume, and
wherein the volume of the first subsection of the second reactor section is in the range of 10 to 200 times the reference volume and
wherein the volume of the total second reactor section is in the range of 20 to 2,000 times the reference volume and
wherein the reactor comprises in the first subsection of the second reactor section and/or in the plasma section in the range downstream in the flow direction of the main stream of the foot points of the electric arc on the inner surface of the hollow channel of the anode down to the end of the plasma section at least at one point a flow cross-section transverse to the flow direction of the main stream which is greater by at least a factor of 5 in comparison with the average flow cross-section of the anode transverse to the flow direction of the main stream in the range of the foot points of the electric arc on the inner surface of the hollow channel of the anode.

The above facility which comprises the device for the production of hydrogen and solid carbon and the power plant unit not only allows storing electricity in the form of hydrogen but it also provides for an ecologically reasonable re-conversion of the produced hydrogen to electricity. The facility according to the invention may provide or consume almost any desired amount of energy and hydrogen. It may either be operated in such a way that it generates an amount of electrical energy which can be supplied to an external power grid or it may be operated in a way that it draws a certain amount of electrical energy from an external power grid and produces hydrogen. High annual full load hours of operation may be achieved for both units of the facility, the power plant unit and the device for the production of hydrogen and solid carbon.

### Definitions

The term "at least one first feed line" means 1, 2, 3, 4, 5, or more first feed lines. In some embodiments, at least one first feed line is one first feed line. In further embodiments, at least one first feed line means 2 or more first feed lines.

Likewise, the term "at least one second feed line" means 1, 2, 3, 4, 5, or more second feed lines. In some embodiments, at least one second feed line is one second feed line. In further embodiments, at least one second feed line means 2 or more second feed lines.

The term "reactor" as used in the present invention refers to a chemical reactor. The reactor is a closed vessel comprising a reactor space in which chemical reactions takes place. Via inlets and outlets substances may be introduced into the reactor space or withdrawn therefrom, respectively. Here, the reactor is a closed vessel suitable for carrying out the process for the production of hydrogen and solid carbon according to the present invention based on a thermal plasma process, wherein the thermal plasma is generated by an electric arc. One general example of a reactor is the so-called Huels reactor (cf. Acetylene, Paessler et al., Ullmann's Encyclopedia of Industrial Chemistry, doi:10.1002/14356007.a01_097.pub4, 2011). This reactor is used for the production of acetylene. The device of the present invention comprises an electric arc reactor having specific features differing from the Huels reactor which are advantageous to put the claimed process into practice. The claimed device comprising the electric arc reactor can be used to carry-out the claimed process.

The term "anode", as used for the purpose of the definition of the present invention, is understood narrowly. The anode stretches down to the beginning of the second reactor section which is identical to the beginning of the first subsection of the second reactor section, i.e., the position of the at least one second feed line along the flow direction of the main stream, even though parts beyond the beginning of the first subsection of the second reactor section may have the same electrical potential as the anode. Other parts of the plasma section, e.g., a magnetic device or a device for fluid-dynamically inducing swirling of the plasma gas, do not belong to the anode as defined according to the present invention, even though they may have the same electric potential as the anode.

The term "plasmaeous plasma gas" refers to a gas which is present in a plasma state. A gas which is merely intended to be introduced and/or treated in a reactor for generating a thermal plasma by means of an electric arc, but which is not or not yet present in a plasma state does not fall under the definition of a plasmaeous plasma gas. A gas which exits a reactor for generating a thermal plasma by means of an electric arc and is not or no longer present in a plasma state does, likewise, not fall under the definition of a plasmaeous plasma gas.

According to A. Fridman (Plasma Chemistry, Cambridge University Press, 2009), a gas which is present in a plasma state is generally defined as an ionized gas, i.e. a gas containing at least one electron which is not bound to an atom or molecule, converting the atoms or molecules into positively charged ions. Preferably, a gas which is present in a plasma state contains electrically charged particles in an amount which is sufficient to affect and change its electrical properties and behavior relative to the normal gas state. An example of an electrical property is the electrical conductivity. The electrical conductivity is increased in the plasma state of a gas, especially in the plasma state which is adopted at elevated temperatures. Conceptually, the correlation of the electrical conductivity with the plasma state and the temperature of a gas may be explained as follows: It is known that the degree of ionization increases with temperature (for example shown by tabulated data for hydrogen, nitrogen, oxygen, air and selected noble gases in M. I. Boulos, Thermal Plasmas, Fundamentals and Applications, Vol. 1, 1994). Due to the enhanced mobility of opposite charges, an increased degree of ionization then also comes along with an increased electrical conductivity.

Moreover, a plasmaeous plasma gas in the sense of the current invention is preferably characterized by the fact that the electrical conductivity of the respective plasmaeous plasma gas at a given density is at least 1 order of magnitude, preferably 2 orders of magnitude, even more preferably 4 orders of magnitude higher than the electrical conductivity of the corresponding gas at room temperature and the same density .

Whereas non-plasma state gases at room temperature (i.e. without external electrical or other excitation) have electrical conductivities below 10-22 S/m, a gas in a plasmaeous state according to the present invention is characterized by an electrical conductivity of at least 10-21 S/m, preferably at least 10-20 S/m, even more preferably at least 10-18 S/m.

In this context, the skilled person can measure the electrical conductivity of a gas by a technique which is analogous to the flame ionization detection method.

A gas which is present in a plasma state is preferably generated by the use of electrical energy, for example by subjecting a gas to a strong electromagnetic field, for example an electromagnetic field which is generated in the surrounding of an electric arc.

A plasmaeous plasma gas, i.e. a gas present in a plasma state, can at least be encountered at one point of a flow cross-section transverse to the flow direction of the main stream in the current reactor.

The term "C₁- to C₄-alkane-containing gas" as used in the present invention refers to a gas which mainly comprises methane, ethane, propane, butane, 2-methyl-propane, or mixtures thereof. The sum of the C₁- to C₄-alkane(s) in the gas is at least 10 vol. %, preferably at least 25 vol. %, more preferably at least 50 vol. %, more preferred at least 75 vol. %, even more preferred at least 90 vol. %. In some embodiments, the C₁- to C₄-alkane-containing gas is natural gas. In certain embodiments, the C₁- to C₄-alkane-containing gas contains methane and/or propane. This is advantageous as both gases can be obtained in large quantities, e.g., methane from natural gas and propane from the production of hydrogenated vegetable oils. Most preferably, the C₁- to C₄-alkane containing gas is natural gas or a methane-containing gas. This means that either natural gas may be used as a gas comprising methane or another gas comprising methane. Most preferably, the C₁- to C₄- alkane-containing gas contains methane, in particular at least 25 vol. % methane, more preferably at least 50 vol. % methane, even more preferably at least 75 vol. % methane, most preferably at least 90 vol. % methane. If high shares of methane are comprised in the C₁- to C₄-alkane-containing gas, it is clearly preferred to install the inventive facility in proximity to a biorefinery.

The C₁- to C₄-alkane-containing gas may include higher boiling components, e.g., C₅-alkanes, olefins, aromatic components, such as benzene, and mixtures thereof, or even mixtures with components containing low amounts of oxygen, e.g., long chain aldehydes like C₁₂H₂₄O. In one example, the C₁- to C₄-alkane-containing gas may include higher boiling components in the range of 0.1 to 50 vol. %, preferably in the range of 0.5 to 30 vol. %, even more preferred in the range of 1 to 10 vol. %. Most preferably, however, the C₁- to C₄-alkane containing gas does, however, not include any of the mentioned higher boiling components.

In certain embodiments, the C₁- to C₄-alkane-containing gas comprises less than 5 vol. % O₂, preferably less than 2 vol. % O₂, most preferably less than 1 vol. % O₂, less than 10 vol. % CO, preferably less than 5 vol. % CO, most preferably less than 2.5 vol. % CO, less than 10 vol. % CO₂, preferably less than 5 vol. % CO₂, most preferably less than 2.5 vol. % CO₂, and/or less than 10 vol. % N₂, preferably less than 5 vol. % N₂, most preferably less than 1 vol. % N₂. Most preferably, however, the C₁- to C₄-alkane containing gas is essentially free of O₂, CO, CO₂ and N₂.

In certain embodiments of the present invention the C₁- to C₄-alkane-containing gas comprises from 0.1 up to 25 vol. %, preferably from 0.5 up to 15 vol. %, more preferably from 1 up to 5 vol. %, H₂. The C₁- to C₄- alkane-containing gas may also comprise from 0.1 up to 10 vol. %, preferably from 0.5 up to 7 vol. %, more preferably from 1 up to 5 vol. %, acetylene. Most preferably, however, the C₁- to C₄-alkane containing gas is essentially free of H₂ and acetylene.

### Device for the production of hydrogen and solid carbon

The device for the production of hydrogen and solid carbon may further include at least one of a device for enrichment of hydrogen; at least one heat exchanger; a storage tank for at least temporarily storing hydrogen.

Devices for the enrichment of hydrogen, i.e. separation of hydrogen from other gases and hydrocarbons such as methane, CO and N₂, are known from prior art. In a preferred embodiment the device for the enrichment of hydrogen is a pressure swing adsorption (PSA) unit. A PSA process is a cyclic process involving the adsorption of impurities, such as CO, CO₂, CH₄ and N₂, from a hydrogen-rich gas stream at an elevated pressure on a solid adsorbent such as a molecular sieve. The operation is carried out at room temperature and preferably at elevated pressure. Several adsorption vessels (adsorbers) are employed so that the process can be driven continuously and one of the adsorbents can be recovered, while the other is being used.

The at least one heat exchanger serves to improve the overall energy balance. Heat that is not utilised in the plasma reactor may advantageously be used for other processes within the device for the production of hydrogen and solid carbon, or within in the power plant unit or in other plants. A method that may be used to figure out, for which purposes the heat can be most efficiently used, is, for instance, the pinch analysis.

The storage tank for at least temporarily storing hydrogen is especially useful in situations in which there may be a temporal mismatch between the production and consumption profile of hydrogen produced by the device for the production of hydrogen and solid carbon. The hydrogen may then be temporarily stored in the tank and may be re-converted to electricity or, alternatively, be utilised chemically or for other purposes at a later point of time. Alternatively, hydrogen may be fed into a hydrogen pipeline or hydrogen network which assists with distributing the produced hydrogen according to the needs of the consumers. The produced hydrogen can, for example, be provided to refineries, hydrogen fueling stations and/or industrial furnaces. Especially, the public transportation system may be a big consumer of the produced hydrogen.

The device for the production of hydrogen and solid carbon may further include at least one of a first gas outlet and a second gas outlet. The first gas outlet and/or the second gas outlet may be connected to a fuel gas inlet of the power plant unit, preferably with an intermediate compression stage. The first gas outlet may be located downstream of the at least one device for separating solid carbon from hydrogen and upstream of the device for enrichment of hydrogen. The second gas outlet may be located downstream of the device for enrichment of hydrogen. The hydrogen which flows through the second gas outlet preferably has a higher purity than the hydrogen which flows through the first outlet. Preferably, the hydrogen which flows through the second gas outlet has a purity of at least 95.0 vol.-%, preferably of at least 99.0 vol.-%, even more preferably at least 99.9 vol.-%.

The first and the second gas outlet preferably each comprise several fittings such as two-way-valves and/or three-way-valves. These fittings and corresponding control mechanisms ensure that the flow paths between the device for the production of hydrogen and solid carbon and the power plant unit can be controlled according to the needs and the current mode of operation.

In one embodiment, the fuel gas inlet of the power plant unit is connected to the first gas outlet and/or the second gas outlet of the device for the production of hydrogen and solid carbon and to a reservoir with a C₁- to C₄-alkane-containing gas. In this way, the composition of the fuel gas can be adapted in wide ranges. The fuel gas which enters the combustor of the power plant unit may contain purposely high shares of hydrogen in the range of 25-100 vol.-%, preferably of 40-80 vol.-%, more preferably of 50-70 vol.-% or moderate shares of hydrogen in the range of between 0.5 and 25 vol.-%, preferably between 1 and 25 vol.-% and more preferably 1 and 20 vol.-%. The ratio of hydrogen to C₁- to C₄-alkane(s) in the alkane-containing gas in the inlet of the power plant unit is preferably adjusted in such a way that the resulting inlet stream for the power plant has suitable fuel gas parameters such as density, Wobbe-index and/or flame speed in desired ranges. In addition, a further pipeline for separate fuel gases such as propane and butane can be connected to the inlet of the power plant unit in order to adjust the fuel gas parameters.

The plasma reactor which is included in the device for the production of hydrogen and solid carbon preferably comprises in the first subsection of the second reactor section and/or in the plasma section in the range downstream in the flow direction of the main stream of the foot points of the electric arc on the inner surface of the hollow channel of the anode down to the end of the plasma section at least at one point a flow cross-section transverse to the flow direction of the main stream which is greater by not only a factor of 5, but at least a factor of 10, in comparison with the average flow cross-section of the anode transverse to the flow direction of the main stream in the range of the foot points of the electric arc on the inner surface of the hollow channel of the anode.

Further preferably, the flow cross-section transverse to the flow direction of the main stream in the range from the foot points of the electric arc on the inner surface of the hollow channel of the anode down to the most upstream point in the flow direction of the main stream at which the flow cross-section transverse to the flow direction of the main stream is greater by at least a factor of 5, preferably a factor of 10, in comparison with the average flow cross-section of the anode transverse to the flow direction of the main stream in the range of the foot points of the electric arc on the inner surface of the hollow channel of the anode is at any point at least 60 %, preferably at least 80 %, more preferred at least 90 %, relative to the average flow cross-section transverse to the flow direction of the main stream at the foot points of the electric arc on the inner surface of the hollow channel of the anode. This ensures that there is, if at all, only a limited reduction of the flow cross-section between the foot points of the electric arc on the inner surface of the hollow channel of the anode and the point at which the flow cross-section transverse to the flow direction of the main stream is enlarged. This prevents an undesired pressure drop and material stress in this zone of the reactor.

According to another embodiment, the reference volume of the plasma reactor which is included in the device for the production of hydrogen and solid carbon preferably is in the range of 0.001 to 0.2 m³. Moreover, the volume of the first subsection of the second reactor section may be in the range of 20 to 100 times the reference volume and the volume of the volume of the total second reactor section may be in the range of 40 to 1,000 times the reference volume.

Preferably, the anode which is comprised by the plasma reactor has a cylindrical shape having a coaxial hollow channel. In preferred embodiments, the anode and/or the cathode are cooled electrodes, wherein the cooling is preferably liquid cooling, more preferably water cooling. This ensures reduced erosion and long-lasting operation of the electrodes. In further embodiments, the anode and/or the cathode are made of materials comprising less than 10 wt. % of graphite or other solid carbon materials. However, graphite or solid carbon-based electrodes typically exhibit higher deterioration rates and require higher investment costs than metal-based electrodes. Accordingly, in preferred embodiments the anode and the cathode of the reactor are metal electrodes.

In further embodiments, the anode and cathode are concentric and also the cathode has a hollow channel with the main axis extending along the flow direction of the main stream, wherein the hollow channel has two opposing ends, wherein the end facing into the direction opposite to the flow direction of the main stream is closed and wherein the end facing into the flow direction of the main stream of the plasma gas is open. Preferably, this open end facing into the flow direction of the main stream of the plasma gas is positioned up-stream and concentric to the open end of the anode facing into the direction opposite to the flow direction of the main stream. The term "closed" in the context of the end of the hollow channel of the cathode facing into the direction opposite to the flow direction of the main stream means that the end of the channel is completely closed or that the flow cross-section transverse to the flow direction of the main stream is reduced by at least 90 % based on the area of the flow cross-section in comparison with the average flow cross-section of the cathode transverse to the flow direction of the main stream in the range of the foot points of the electric arc on the inner surface of the hollow channel of the cathode. In these embodiments, the anode and cathode are arranged such that the foot points of the electric arc contact the inner surface of the cathode and the inner surface of the anode, respectively. In preferred embodiments, the anode and the cathode are arranged such that there is a gap in the direction of the main stream between the end of the cathode facing into the flow direction of the main stream and the end of the anode facing into the direction opposite to the flow direction of the main stream. The length of said gap is preferably at least 0.3, more preferably at least 0.5, times the average inner diameter of the hollow channel of the anode in the range of the foot points of the electric arc on the inner surface of the hollow channel of the anode. In some embodiments, the at least one first feed line is arranged such that the plasma gas is introduced into the plasma section of the reactor via the gap between the anode and cathode.

Shape and location of foot points of electric arcs on the cathode and/or on the anode typically vary over time during operation, not only during ramp-up, shut down and load changes, but also during steady state operation. Especially, in case of anodes having a hollow channel and wherein the foot points of the electric arc are on the inner surface of the hollow channel of the anode, the location of the foot points may vary over time and even in steady state operation both along the perimeter of the anode but also at least to a finite extent upwards and downwards in the flow direction of the main stream. The range of the locations of foot points on the inner surface of the hollow channel of the anode in the flow direction of the main stream typically depends on the current mode of operation. For example, if all other process parameters are kept constant, an increase in electrical load results in an elongation of the electric arc and hence in a shift of the range of locations of foot points on the inner surface of the hollow channel of the anode to an area on the surface of the hollow channel of the anode more downstream in the flow direction of the main stream. In the context of the present invention, with respect to the inner surface of the hollow channel of the anode, the term foot points refers to the location of the foot points which is most downstream under all continuous reactor operation modes. The most extended reach of foot points can for example be identified upon revision of an anode after operation based on an analysis of the material erosion on the inner surface of the hollow channel of the anode. The material erosion is namely higher at the part of the inner surface which is contacted by the foot points compared to surface sections which the arc has not reached during operation. The foot points define an area in which the electric arc contacts the anode. Likewise, the area where foot points are located on the inner surface of a hollow channel of a cathode during operation may be identified upon revision after operation.

As already indicated before, the reactor comprises at least one sudden expansion of the flow cross-section. The sudden expansion may be a sudden expansion of the flow cross-section transverse to the flow direction of the main stream which has an opening angle of at least 20 °, preferably at least 45 °, more preferred at least 75 °, into the flow direction of the main stream relative to the main stream axis. This reactor configuration helps to mix the C₁- to C₄-alkane-containing gas which is introduced into the reactor via the at least one second feed line and the plasmaeous plasma gas and to broaden the residence time distribution of the atoms of the mixture. Especially, the sudden expansion improves backmixing of a portion of solid particles rich in carbon whose surfaces have a catalytic impact on decomposition of hydrocarbons and which may grow to a larger size through backmixing. Also, further means like means for the induction of turbulence and/or backmixing may broaden the residence time distribution and further improve the device and the process of the present invention. Hence, in some embodiments the second reactor section comprises at least one additional device for inducing additional turbulence and/or backmixing of the mixture, preferably being positioned downstream of the at least one second feed line in the flow direction of the main stream. In some embodiments, the at least one additional device is positioned downstream of the most upstream point in the flow direction of the main stream at which the flow cross-section transverse to the flow direction of the main stream is greater by at least a factor of 5, preferably by at least a factor of 10, in comparison with the average flow cross-section of the anode transverse to the flow direction of the main stream in the range of the foot points of the electric arc on the inner surface of the hollow channel of the anode. In these embodiments, the at least one additional device may be positioned downstream of the at least one second feed line in the flow direction of the main stream. The at least one additional device for inducing turbulence and/or backmixing of the mixture may be selected from the group consisting of a passive grid, a static mixer, a bend of the reactor, and combinations thereof, wherein preferably the bend of the reactor induces a change of the flow direction of the mixture relative to the flow direction of the main stream by at least 80 °, preferably at least 135 °. In certain embodiments of the present invention, the reactor comprises two or more sudden expansions, preferably in the second reactor section, more preferably in the first and/or second subsection of the second reactor section. In preferred embodiments, at least 5 % of the atoms of the mixture resulting from the plasmaeous plasma gas leaving the plasma section and the C₁- to C₄-alkane-containing gas of the at least one second feed line have a residence time in the second reactor section which deviates in absolute numbers by at least 5 % from the mean residence time of all atoms of the mixture resulting from the plasmaeous plasma gas leaving the plasma section and the C₁- to C₄-alkane-containing gas of the at least one second feed line in the second reactor section.

In the context of the above embodiment, the "residence time", the "mean residence time", and the "residence time distribution" in the second reactor section, if not specified otherwise, refers to the residence time, the mean residence time, and the residence time distribution in the total second reactor section. Moreover, the term "in absolute numbers by at least 5 % deviation from the mean residence time" means that the corresponding atoms have a residence time of up to 95 % or 105 % and more relative to the mean residence time.

Preferably, at least 10 % of the atoms of the mixture resulting from the plasmaeous plasma gas leaving the plasma section and the C₁- to C₄-alkane-containing gas of the at least one second feed line have a residence time in the second reactor section which deviates in absolute numbers by at least 10 % from the mean residence time of all atoms of the mixture resulting from the plasmaeous plasma gas leaving the plasma section and the C₁- to C₄-alkane-containing gas of the at least one second feed line in the second reactor section, more preferred by at least 15 %, even more preferred by at least 20 %, from the mean residence time of all atoms of the mixture resulting from the plasmaeous plasma gas leaving the plasma section and the C₁- to C₄-alkane-containing gas of the at least one second feed line in the second reactor section.

The design of the device for the production of hydrogen and solid carbon allows for an efficient and economically sustainable production of hydrogen and solid carbon. Although acetylene tends to be formed and react to benzene and higher aromatic compounds so that disturbing tar layers are deposited on the walls of plasma reactors or the walls of subsequent equipment, the walls of the device for the production of hydrogen and solid carbon according to the current invention are essentially free of such deposits, even after the device has been operated for a longer period of time.

Moreover, it should be noted that the device for the production of hydrogen and solid carbon is preferably free of a quenching unit. By omitting a quenching unit, acetylene decomposition can be promoted and acetylene stabilization, in turn, can be effectively avoided. In this way, efficiency in terms of hydrogen production can be increased.

The energy needed to split more C₁- to C₄-alkane-containing gas into hydrogen and solid carbon, e.g., carbon black, may partially be covered by the heat which develops upon decomposition of acetylene. Hence, is possible to increase the capacity of a plasma reactor while reducing the total specific electricity demand for splitting the C₁- to C₄-alkane-containing gas.

### Power Plant Unit

In a preferred embodiment of the invention, the power plant unit is a power plant unit which is exclusively operated with fluid input streams. Preferably, the power plant unit is a simple-cycle plant, in particular a gas-fired power plant. The gas-fired power plant may include a combustor, a gas-fired steam turbine and a generator. Alternatively, the power plant unit can also be a gas-fired combined cycle power plant, a gas engine, or a fuel cell, with the fuel cell being the least preferred. Summarizing, the power plant unit is most preferably a gas-fired power plant or a gas-fired combined cycle power plant.

It is further preferred that the power plant unit is any power plant unit except from a coal-fired power plant unit. The reason is that a conventional coal-fired power plant unit, especially one without combined production and technical use of heat, would deteriorate the overall CO₂ balance of the process compared to other technologies.

Moreover, looking at several of the inventive facilities, it is clear that the power plant unit may be different in each facility. In this way, it is possible to rely on a pool of different power plant technologies.

Using a simple-cycle plant as a power plant unit reduces the overall complexity of the facility. Further, if the simple-cycle plant is a gas-fired power plant, it is possible to take advantage of the recent progresses in the design of gas turbines and combustors: In particular, modern gas-fired power plants are able to cope with a very high share of hydrogen as a fuel gas and, thus, allow a cleaner process with less emissions of greenhouse gases.

A combined-cycle power plant comprises both, a gas turbine and a steam turbine. In this way, it can produce up to 50 percent more electricity from the same amount of fuel than a simple-cycle plant.

Gas engines are frequently used at small- to medium-scale power production. Gas engines are advantageous since many commercially available gas engines are designed modular. Therefore, a basic gas engine module may be easily extended without incurring very high costs. Moreover, if there is a possibility to build a device for the production of hydrogen and solid carbon close to a sufficiently large, gas engine-based power production site, it is advantageous to use such gas engines as the power plant units in order to provide a facility according to the present invention.

If the power plant unit is a fuel cell (least preferred embodiment), various technologies are available. These should be selected according to the demands for the purity of the fuel gas. The PEM-technology (Proton Exchange Membrane), for instance, requires quite pure fuel gases, whereas the SOFC-technology (Solid Oxide Fuel Cell) is not that sensitive to residues of natural gas.

Moreover, in another advantageous embodiment, the power plant unit which is comprised by the inventive facility has a carbon footprint from 0 to 500 g_{CO2}/kWh_{used}, more preferably from 0 to 450 g_{CO2}/kWh_{used}, even more preferably from 0 to 400 g_{CO2}/kWh_{used}, most preferably from 0 to 350 g_{CO2}/kWh_{used}.

The use of a power plant unit with such a low carbon footprint contributes to an overall economical and sustainable process.

In this context, the "carbon footprint" of a power plant unit denotes the annually averaged amount of CO₂ emitted into the atmosphere by the power plant unit itself upon combustion of fossil fuels (e.g., natural gas, fossil heating oil, hard coal or lignite including derived fuels and wastes) per respective amount of energy produced by the power plant.

The unit "kWh_{used}" must be seen in the context of power plants which not only provide electricity but also heat for technical applications, such as industrial process heat or district heating. In this context, the unit "kWh_{used}" denotes the amount of energy which is technically used either as heat or as electrical energy. Heat which is lost to the environment or which is absorbed by a cooling fluid without any specific technical benefit does not fall under this amount of energy and does, thus, not contribute to the "kWh_{used}".

Hence, a power plant unit having a carbon footprint of 0 g_{CO2}/kWh_{used} is a power plant which is operated with zero CO₂ emission to the atmosphere, for example renewable power plants such as wind and PV power plants, alternatively nuclear power plants or power plants with capture of all CO₂ from the flue gas and its sequestration before release of the remainder of the flue gas to the atmosphere.

According to a second, but less preferred embodiment, the power plant unit has a carbon footprint from 1 to 500 g_{CO2}/kWh_{used}, more preferably from 2 to 450 g_{CO2}/kWh_{used}, even more preferably from 5 to 400 g_{CO2}/kWh_{used}, most preferably from 5 to 350 g_{CO2}/kWh_{used}. These non-zero lower limits apply to power plants that have to be fueled with a small share of non-renewable energy sources for some reason or with fuels with small carbon footprint such as some renewable fuels.

However, in order to ensure an overall economical and sustainable process, it is preferred if the power plant unit does not comprise any coal fired furnaces. Such furnaces could, in principle, be used for burning the carbon which is produced by the device for the production of hydrogen and solid carbon. Yet, this has a negative impact on the overall CO₂-footprint. Hence, the carbon which is produced by the device for the production of hydrogen and solid carbon is rather used in chemical processes, for example as carbon black or it is sequestered.

### Further Components and Features of the Facility

The facility according to the present invention preferably further comprises means for powering the device for the production of hydrogen and solid carbon with power from the external power grid, electrical power from said power plant unit or a mix of the aforementioned power types. The means may be at least one of a grid connector and a transformer.

In one embodiment, the at least one device for the production of hydrogen and solid carbon the power plant unit are located at different sites. In this case, a distance between the at least one device for the production of hydrogen and solid carbon the power plant unit may be at least 5 km, more preferably at least 10 km, most preferably from 10 km to 200 km.

Apart from that, the facility according to the present invention may further comprise at least one controller. One controller is configured to output a command which determines the operation state of the device for the production of hydrogen and solid carbon and the power plant unit depending on an information with respect to a power in an external power grid. Preferably, this controller is configured to output
i) a command to run the power plant unit at a high load and to shut down the device for the production of hydrogen and solid carbon according to a first mode, or
ii) a command to run the device for the production of hydrogen and solid carbon at a high load and to shut down the power plant unit according to a second mode, or
iii) a command to run the device for the production of hydrogen and solid carbon and the power plant unit at high loads according to a third mode.

Within the context of the current invention, a "high load" is synonymous with more than 50 % of the maximum load (i.e. full load or maximum design capacity of the facility), preferably more than 70 % of the maximum load or more preferably more than 90 % of the maximum load. A command to "shut down" one of the units includes a command to completely shut down the unit or to run it at a reduced load of less than 30 % of the maximum load or preferably less than 20 % of the maximum load. The controller is configured to determine the exact loads based on the information with respect to the power in the external power grid. However, the controller may also include learning algorithms. In this way the determination of the exact loads takes the success of previous commands and operation modes into account. The success may be rated according to the degree to which a stabilization of power supply in the external grid has been achieved or according to the system wear that has been caused. The facility may thus for example show a hysteresis behavior. Alternatively, the facility may increasingly use predictive tools for inclusion of predicted information of the electricity grid within the near-term future.

### Method for Operating the Facility

In another aspect, the present invention provides a method for operating the facility that has been described above, wherein the at least one device for the production of hydrogen and solid carbon and the power plant unit are run in such a way that the sum of full load hours of the respective plants or units is not more than 15,000 full load hours per year.

Preferably, the method includes running the at least one device for the production of hydrogen and solid carbon and the power plant unit for not more than 14,000 full load hours per year, more preferably not more than 13,000 full load hours per year, even more preferably not more than 12,000 full load hours per year.

On the one hand, the power plant unit may be run for at least 250 full load hours per year during times at which the at least one device for the production of hydrogen and solid carbon runs at not more than 50 % of its design capacity, in particular at 0 % of its design capacity, preferably for at least 500 full load hours per year during times at which the at least one device for the production of hydrogen and solid carbon runs at not more than 50 % of its design capacity, in particular at 0 % of its design capacity, more preferably for at least 750 full load hours per year during times at which the at least one device for the production of hydrogen and solid carbon runs at not more than 50 % of its design capacity, in particular at 0 % of its design capacity, even more preferably for at least 1,000 full load hours per year during times at which the at least one device for the production of hydrogen and solid carbon runs at not more than 50 % of its design capacity, in particular at 0 % of its design capacity, most preferably for at least 1,500 full load hours per year during times at which the at least one device for the production of hydrogen and solid carbon runs at not more than 50 % of its design capacity, in particular at 0 % of its design capacity.

On the other hand the controller may be advantageously configured in such a way that it runs the at least one device for the production of hydrogen and solid carbon for at least 250 full load hours per year during times at which the power plant unit runs at not more than 50 % of its design capacity, in particular at 0 % of its design capacity, preferably for at least 500 full load hours per year during times at which the power plant unit runs at not more than 50 % of its design capacity, in particular at 0 % of its design capacity, preferably for at least 1,000 full load hours per year during times at which the power plant unit runs at not more than 50 % of its design capacity, in particular at 0 % of its design capacity, more preferably for at least 1,500 full load hours per year during times at which the power plant unit runs at not more than 50 % of its design capacity, in particular at 0 % of its design capacity, most preferably for at least 2,000 full load hours per year during times at which the power plant unit runs at not more than 50 % of its design capacity, in particular at 0 % of its design capacity.

If all other conditions are met (i.e. the maximum sum of full load hours is not yet exceeded), the method according to the present invention may also be determined by the action of a controller. In this case, when the controller receives a value corresponding to an information with respect to the power in the external power grid as an input, it either
i) outputs a command for running the power plant unit at a high load and for shutting down the device for the production of hydrogen and solid carbon according to a first mode; or
ii) outputs a command for running the device for the production of hydrogen and solid carbon at a high load and for shutting down the power plant unit according to a second mode; or
iii) outputs a command for running the device for the production of hydrogen and solid carbon and the power plant unit at high loads according to a third mode.
The meaning of the term "high load" has already been explained in the context of the facility and the configuration of the controller. The command for shutting down/to shut down has also been outlined before.

The controller preferably operates according to mode iii), if the value is within a predefined tolerance range relative to a reference value. It preferably operated according to mode i) or mode ii), if the value is above or below the tolerance range relative to the reference value respectively.

Hence, operation mode iii) may be regarded as a kind of default operation mode of the facility. A change from the default operation mode to another operation mode is only permitted, if the value or combinations thereof corresponding to an information with respect to the power in the external power grid deviates from a reference value by more than a predefined difference. The difference may be set independently for each of a positive deviation from the reference value and a negative deviation from the reference value. In each case, the difference should be defined in such a way that the operation of the facility does not become too sensible to small deviations of the current value from the reference value. However, the difference must not be set too high in order to make sure that an operation mode which is unfavorable, e.g. in terms of the overall CO2 footprint, may be avoided and instead a more favorable operation mode is achieved.

The value which is received by the controller may be a value corresponding to a current information with respect to the power in the external power grid or a value corresponding to a predicted information with respect to the power in the external power grid for a period of time in the near-term future.

The predefined difference may preferably be determined and adapted in discrete steps or continuously under real conditions. A corresponding determination method may include monitoring the value corresponding to a current information with respect to the power in the external power grid over a certain period of time, especially considering patterns over the course of days and/or weeks and/or years and/or dependent on the current and prognosed power production mix, especially the share of renewable power generation such as from wind and PV plants. Based on the observed courses of values, the predefined differences may be computed dependent on, for example, the time of the day and/or the week and/or the year and/or dependent on the current and/or prognosed mix of power generation and a tolerance range may be derived from those differences. Alternatively, a default value may be set as a predefined difference. This default value may, for instance, be ±30%, preferably ±20%, more preferably ±10%, even more preferably ±5% of the bandwidth of potential values corresponding to a current information with respect to the power in the external power grid.

In one embodiment, the inlet of the power plant unit is supplied with a fuel gas comprising or consisting of natural gas or a mixture comprising or consisting of natural gas and hydrogen containing gas. The hydrogen containing gas is preferably supplied from a first and/or a second gas outlet of the device for the production of hydrogen and solid carbon. The hydrogen share in the fuel gas may be adjusted by determining the ratio of the streams, for example to 0.5-100 vol.-%, more preferably 40-80 vol.-%, even more preferably 50-70 vol.-%. Further preferred hydrogen shares in the fuel gas are 1-25 vol.-% or 1-20 vol.-%. Moreover, the fuel gas may further be mixed with air before entry of the combustion chamber. The mixing ratio depends on the specifications of the power plant unit and may be adapted by the skilled person according to the standards in the power plant technology.

Preferably, depending on the value corresponding to an information with respect to the power in the external power grid and the reference value, there are times in which the thermal plasma generator which is comprised in the device for the production of hydrogen and solid carbon is driven with power from an external power grid and times in which the thermal plasma generator is driven with the electrical power produced by the power plant unit of the present invention. For example, if the power from the external power grid has a too high CO₂ footprint, for instance higher than the power plant unit according to the present invention, the thermal plasma generator is preferably driven with power from the power plant unit of the inventive facility. In cases in which the external power is, to a sufficiently large extent, based on renewable energy sources, it is, however, beneficial to switch the powering mode of the thermal plasma generator and to drive it with power from an external power grid.

Exhaust heat which is generated in the device for the production of hydrogen and solid carbon may find application in other fields: If the facility is located in a densely populated area, it is, for example, preferred, when the exhaust heat or a portion of it is supplied to a district heating grid, particularly in winter time. Another possibility, which is especially beneficial during summer time and/or if the facility is part of a large industrial park, is to provide the exhaust heat or a portion of it to an industrial process. In case the power plant of the facility comprises a steam turbine, the exhaust heat or a portion of it may also be supplied to the steam turbine. In one embodiment, two or more applications of exhaust heat such as described above are combined simultaneously. As the load of the device for the production of hydrogen and solid carbon may vary over time, also the amount and/or the application for which the heat is used may vary. In a preferred embodiment, the amount and/or application for which the heat is used may vary even at constant load of the device for the production of hydrogen and solid carbon.

In the above context, the "exhaust heat" is the excess thermal energy which is generated in the device for the production of hydrogen and solid carbon. In other words, the thermal energy is the process heat which is not utilised for a reaction or a process within the device for the production of hydrogen and solid carbon.

The nature of the present invention will become more clearly apparent and better to be understood in view of the accompanying examples and drawings. The examples and drawings should, however, in no way limit the scope of the invention.

The drawings illustrate the following:
Figure 1 is a device and flow diagram showing the interaction between the power plant unit and the device for the production of hydrogen and solid carbon in the facility according to the present invention.
Figures 2-4 are schemes illustrating the operation of the power plant unit and the device for the production of hydrogen and solid carbon in the facility according to the present invention.
Figure 5 shows three different operation modes of the facility in a simplified representation.
Figure 6 is scheme which illustrates the design of the device for the production of hydrogen and solid carbon.

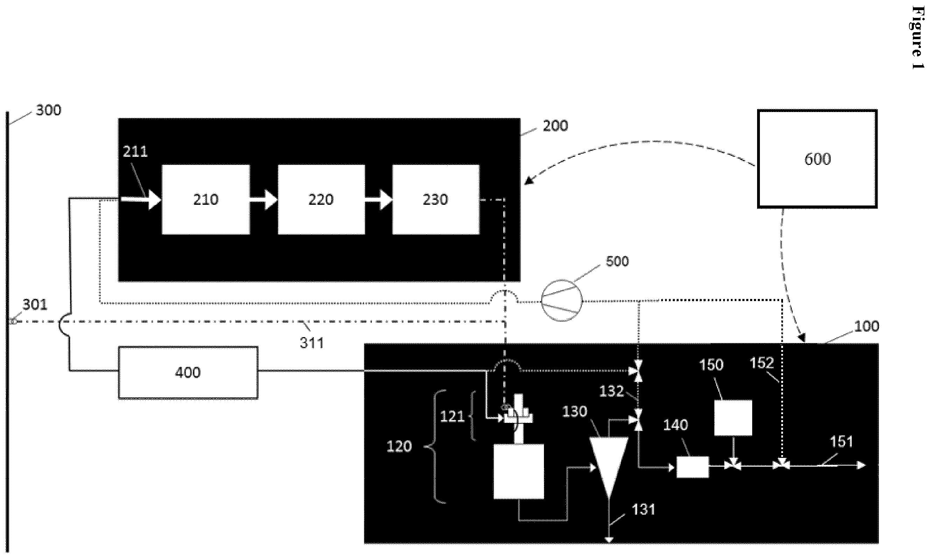

Fig. 1 shows a reservoir 400 for a C₁- to C₄-alkane-containing gas which is connected to a power plant unit 200 and a device for the production of hydrogen and solid carbon 100. The reservoir 400 may either be an external storage tank or a natural feedstock of the C₁-to C₄-alkane-containing gas. Preferably, the reservoir 400 is a natural gas grid.

The flow diagram further indicates the presence of an external power grid 300. The grid 300 is connected to the device for the production of hydrogen and solid carbon 100 in order to supply power to the plasma reactor 120 via power line 311, especially to the plasma section 121. However, the external grid 300 is also connected to the power plant unit 200. This electrical connection allows to feed electrical energy from the generator 230 to the external grid. A grid connector 301 and an optional transformer (not shown) enable the electrical connections between the external grid 300 and the unit 200 and/or the device 100, respectively.

In a first operation mode i) of the facility, the power plant 200 is run and the device 100 is shut down. In this operation mode, the power plant 200 may be run with hydrogen that is fed from the storage tank 150 or with a mix of this hydrogen and natural gas from the reservoir 400. The power which is produced is preferably fed into the external grid via power line 311. In a second operation mode ii), the device 100, i.e. the plasma section 121 of the plasma reactor 120, is supplied with power from the external grid 300 via the power line 311, while the power plant is shut down. In a third operation mode iii), the power plant 200 and the device 100 are running. The power plant unit 200 does either not feed any power to the external power grid 300 or it only supplies a part of the produced power to the external grid 300. The remainder is preferably used to run the device 100.

Which of these abovementioned operation modes is selected, is determined by the controller 600 and depends on an information with respect to the power in the external power grid 300.

In any case, if the plasma reactor 120 is operated, it produces a stream which contains significant amounts of hydrogen and solid carbon, especially carbon black. This stream is supplied to the device 130 for separating solid carbon from hydrogen in order to obtain an outlet stream with reduced amount of solid carbon and a solid outlet stream 131. The solid content in the outlet stream with reduced amount of solid carbon is less than 1.0 wt.-%. The stream with reduced amount of solid carbon may then be divided into a first outlet stream 132 which leaves the device 100 (indicated as a dotted line) and a second stream which is supplied to a device for enrichment of hydrogen 140. The device 140 may be a PSA-unit, i.e. it may comprise at least two adsorber beds (not shown) and serves to create a stream with higher purity in hydrogen. The H₂-enriched outlet stream of device 140 may be split into two streams by a first three-way valve. One stream may be fed into a storage tank 150. The other stream flows to a second three-way valve. At the second three-way valve the stream is split again, namely into an outlet stream 151 which provides an end consumer with H₂ and a stream 152 which is connected to at least one compression stage 500. The splitting ratios may be controlled by appropriate adjustment of the three-way valves.

The first outlet stream 132 and the second outlet stream 152 may be united upstream of at least one compression stage 500 as shown in figure 1. The compression stage 500 may be needed in order to increase the gas pressure to a pressure which is suitable for the combustor 210 of the power plant unit 200. The power plant unit 200 may be further supplied with natural gas from the reservoir 400 so that the inlet stream 211 can contain a broad range of H₂ concentrations, e.g. 20 vol.-% H₂ and 80 vol.-% natural gas. The combustor 210 is specifically designed to handle these high shares of hydrogen and the turbine 220 is designed and made from materials as well as operated such that it withstands potentially high temperatures that may be due to the combustion of hydrogen.

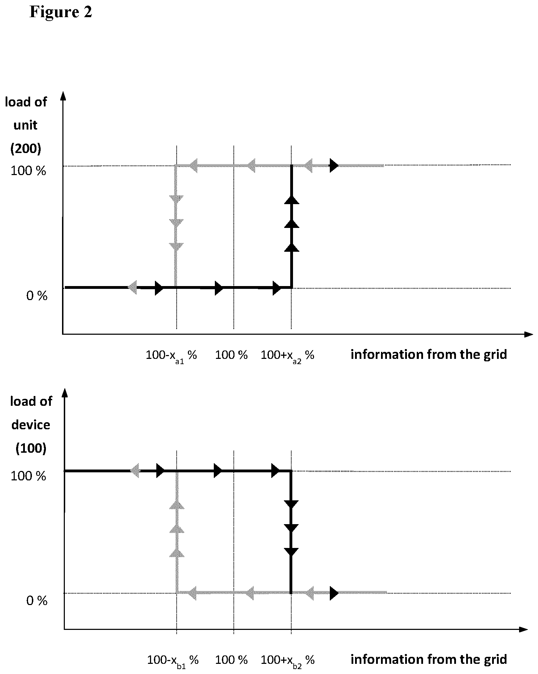

Fig. 2 shows two diagrams, the upper one depicts the operation state of the power plant unit 200 and the lower one depicts the operation state of the device for the production of hydrogen and solid carbon 100. In both diagrams the load is plotted against the information with respect to a power produced in the external power grid ("information from the grid"). As can easily be derived from the labeling of the y-axis, the load may vary from 0% to 100%. The x-axis with the information from the grid is divided into three ranges: The first range covers values up to a specific reference value minus a first predefined difference, i.e. up to the value x_{Refb}-x_{b1} or x_{Refa}-xₐ₁, respectively. The second range is composed of the predefined differences around the respective reference values, x_{Refa} and x_{Refb}. The lower boundary of the tolerance range is x_{Refb}-x_{b1} or x_{Refa}-xₐ₁, respectively, and the upper boundary is x_{Refb}+x_{b2} and x_{Refa}+xₐ₂, respectively. The third range covers values starting from a specific reference value plus a second predefined difference upwards, i.e. from the value of x_{Refb}+x_{b2} or x_{Refa}+xₐ₂ upwards, respectively. The reference values and the predefined differences which define the operation ranges may be equal for the power plant unit 200 and the device 100 respectively, i.e. x_{Refb} = x_{Refa} and x_{b2} = xₐ₂ and x_{b1} = xₐ₁, or they may be different.

As can be seen from the arrows, in a preferred operation mode, the controller may be designed in such a way that the operation exhibits a hysteresis resulting in two valid operation states within the ranges of the predefined differences around the respective reference values. If, for example, the power plant unit 200 has been operated immediately before in a state in which it has been shut down (first range on the left-hand side of the upper diagram), it will remain in this state as long as the value for the information from the grid stays below the upper boundary to the third range on the right-hand side of the upper diagram (x_{Refa}+xₐ₂). Only if the value for the information from the grid exceeds the threshold value to the third range (x_{Refa}+xₐ₂), the power plant unit will receive a command from the controller 600 to change its operation state and to operate at high load (here: at 100 %). On the other hand, if the power plant unit 200 has been operated immediately before at high load (here: at 100 %) and the value corresponding to an information from the external grid decreases below the upper boundary to the third range on the right-hand side of the upper diagram (x_{Refa}+xₐ₂), the power plant unit will be further operated at high load (here: at 100 %). It will only be shut down, if the value for the information from the external grid decreases below x_{Refa}-xₐ₁. Likewise, operation principles apply to the device 100 with the difference that it is operated preferably at low values for the information from the grid and is shut down at high values for the information of the grid.

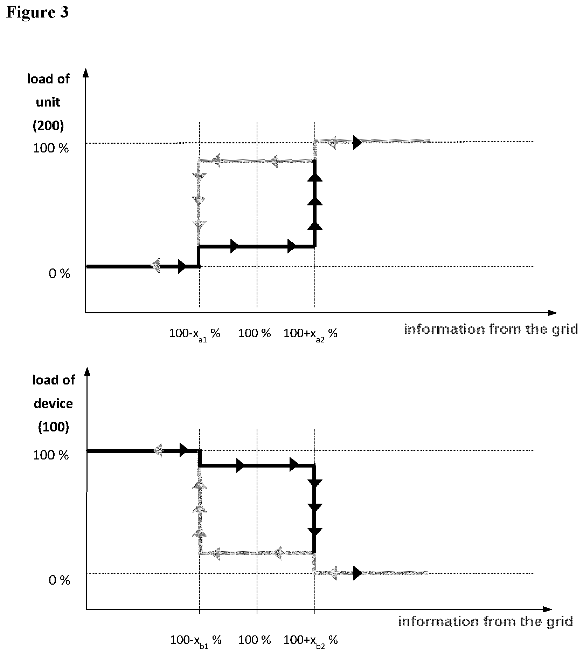

Fig. 3 illustrates that within the ranges of predefined differences around the specific reference values (i.e., from x_{Refa}-xₐ₂ to x_{Refa}+xₐ₂ and from x_{Refb}-x_{b2} to x_{Refb}+x_{b2} respectively) the loads may be different from the loads outside of this range (here: 100 % and 0 % load respectively). For example, within the ranges of predefined differences around the specific reference values (i.e., from x_{Refa}-xₐ₂ to x_{Refa}+xₐ₂ and from x_{Refb}-x_{b2} to x_{Refb}+x_{b2} respectively) the unit 200 and the device 100 may be run at about 15% of the full load and at about 85% of the full load, depending on the previous operation state.

Besides the constant load operation states shown in figures 2 and 3 it is, of course, also possible to operate the power plant unit 200 and the device 100 with linearly or otherwise monotonically decreasing or increasing load ramps. This may be the case within the ranges of predefined differences around the specific reference values and/or within the ranges that cover values up to a specific reference value minus a predefined difference (x_{Refb}-x_{b1} or x_{Refa}-xₐ₁) and or within the ranges that cover values starting from a specific reference value plus a predefined difference (x_{Refb}+x_{b2} or x_{Refa}+xₐ₂) upwards. Likewise, non-linear load profiles may be used within these ranges without departing from the scope of the present invention.

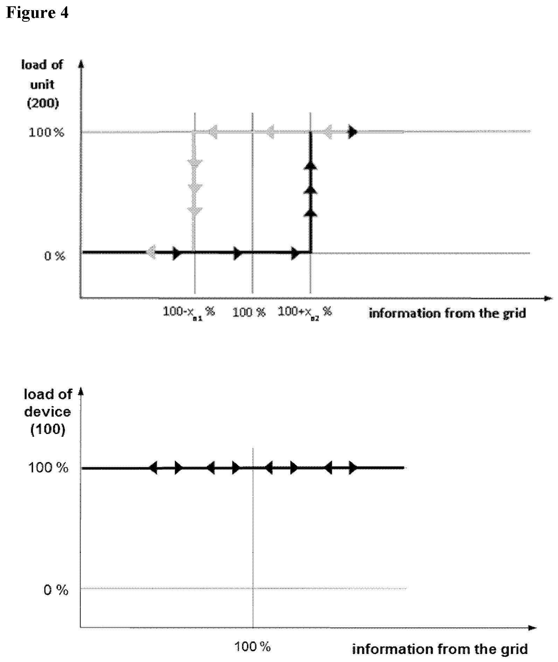

In fig. 4 the device 100 is continuously operated at full load, whereas the load of the unit 200 depends on the information with respect to power in the external power grid as outlined above for figure 2. In times in which the power plant unit 200 is shut down, the device 100 is operated with power from an external grid (e.g. in times of high share of renewable electricity production).

In the embodiments illustrated in fig. 2-4 the values for xₐ₁, xₐ₂, x_{b1} and x_{b2} may be specified separately over time dependent on the prognosis of the value corresponding to an information with respect to a power in an external power grid for the upcoming period of time and the certainty of this prognosis, e.g., the forecast of power fed into the external by wind and PV power installations and/or the demand of electricity from the external grid by other actors. Parameters determining the values for xₐ₁, xₐ₂, x_{b1} and x_{b2} are, among others, the foreseeable duration of upcoming time over which the value corresponding to an information with respect to a power in an external power grid will stay above or below a specific value, the certainty of the prognosis (i.e., the more uncertain the prognosis, the higher the necessary difference of the parameters to the specific value) and the external demand to operate the power plant (e.g., when the power plant unit is a combined heat and power production plant and there is a request for heat).

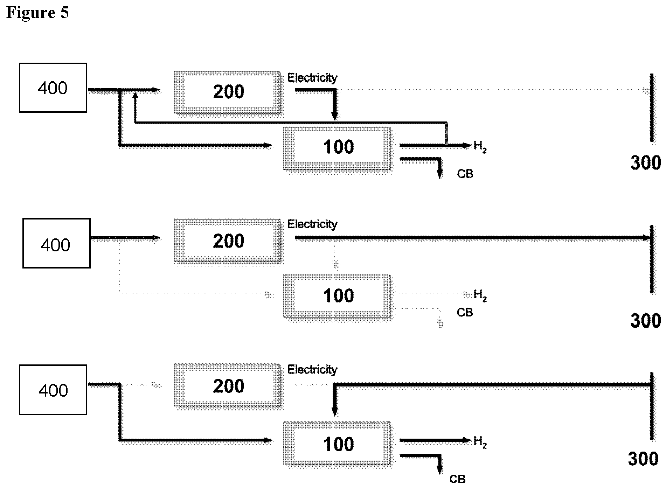

Fig. 5 highlights further options to differentiate the operation modes of the inventive facility. For this purpose, the power plant unit 200 and the device for production of hydrogen and solid carbon 100 are represented by single boxes, respectively. According to the uppermost case, the power plant unit 200 is supplied with a C₁- to C₄-alkane-containing gas from an external reservoir 400. The electricity which is generated is used only to run the device for production of hydrogen and solid carbon 100. At least a portion of the hydrogen H₂ which is produced by the device 100 from an the C₁- to C₄-alkane-containing input stream may be fed back and mixed with the C₁- to C₄-alkane-containing gas in order to obtain fuel gas for the power plant unit 200. Solid carbon (carbon black, CB) can be used elsewhere, e.g. in the printing industry, or it can be sequestered. The illustration in the middle of figure 5 shows an operation mode in which the device 100 is shut down completely and the power, which has been generated by the power plant unit 200, is fed into the external grid 300. In the scheme at the bottom of figure 5 the power plant unit 200 is shut down completely. The device 100 is powered with power from the external power grid 300. The produced hydrogen is stored (not shown in the diagram) or distributed according to the consumer's needs.

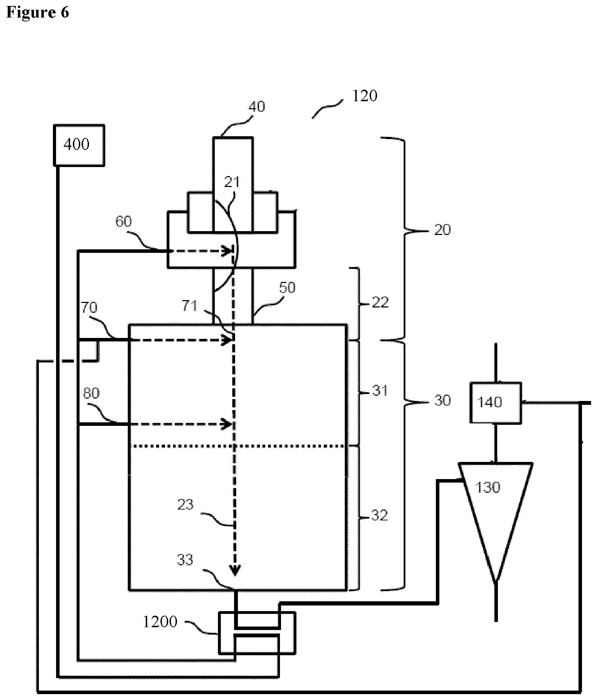

Figure 6 shows the details of an inventive device 100 for the production of hydrogen and solid carbon. The device 100 comprises a reactor 120 for generating thermal plasma by means of an electric arc. The device further comprises a reservoir 400 for providing a C₁-to C₄-alkane containing gas (supply of natural gas), a heat exchanger 1200, a device for separating solid carbon from hydrogen 130, and a device for the enrichment of hydrogen 140.

The reactor 120 comprises a plasma section 20, and a second reactor section 30 directly following the plasma section of the reactor in the flow direction of the main stream 23. The plasma section comprises an anode 50 and a cathode 40 for generating an electric arc 21, wherein the arc extends within the plasma section 20. Furthermore, the plasma section 20 comprises at least one first feed line 60 for introducing the C₁- to C₄-alkane containing gas into the plasma section 20 of the reactor 120.

The second reactor section 30 comprises a first subsection 31 and a second subsection 32, wherein the second subsection is directly downstream of the first subsection in the flow direction of the main stream 23. Furthermore, the second reactor section 30 comprises out-let means 33 for discharging components. Besides that, the first subsection 31 comprises at least one second feed line 70 for introducing a the C₁- to C₄-alkane containing gas into the second reactor section 30 of the reactor 120.

Last but not least, reference number 71 marks the point, upstream of which there is a sudden expansion of the flow cross-section transverse to the flow direction of the main stream 23 which has an opening angle of about 90 ° relative to the flow direction of the main stream.

## Claims

1. Facility comprising
a power plant unit (200), and
at least one device (100) for the production of hydrogen and solid carbon from a C₁- to C₄-alkane-containing gas by use of electric energy which includes a plasma reactor (120) and a device (130) for separating solid carbon from hydrogen,
wherein the plasma reactor (120) comprises
i) a plasma section (20) comprising
• an anode (50) and a cathode (40) for generating an electric arc (21), the arc (21) extending within the plasma section (20), and
• at least one first feed line (60) for introducing the C₁- to C₄-alkane-containing gas into the plasma section (20) of the plasma reactor (120),
• wherein the anode (50) has a hollow channel along the flow direction of a main stream of the gas (23) which has an inner surface, an outlet in the flow direction of the main stream of the gas (23) which forms the open end of the anode (50) in the flow direction of the main stream of the gas (23), and at least one inlet for receiving the C₁- to C₄-alkane-containing gas introduced into the plasma section of the reactor via the at least one first feed line (60) wherein the inlet forms the open end of the anode (50) facing into the direction opposite to the flow direction of the main stream of the gas (23), and wherein the anode (50) is configured such that the gas flows through the hollow channel via the open end of the anode (50) facing into the direction opposite to the flow direction of the main stream of the gas (23) and the open end of the anode in the flow direction of the main stream of the gas (23), wherein the gas contacts the inner surface of the hollow channel of the anode (50) on its passage through the anode (50), and
• wherein said anode (50) and said cathode (40) are arranged so that the arc (21) generated by them is formed in said plasma section (20) to form a plasmaeous gas in said plasma section (20) from the C₁- to C₄-alkane-containing gas introduced into said plasma section (20) through said at least one first feed line (60), and wherein the foot points of the electric arc (21) contacting the anode (50) are located on the inner surface of the hollow channel of the anode (50), and
ii) a second reactor section (30) directly downstream of the plasma section (20) of the plasma reactor (120) in the flow direction of the main stream of the gas (23), the second reactor section (30) comprising
• a first subsection (31) and a second subsection (32), wherein the second subsection (32) is directly downstream of the first subsection (31) in the flow direction of the main stream of the gas (23), and
• outlet means (33) for withdrawing components from the reactor, wherein the outlet means are located at the end of the second reactor section (30) in the flow direction of the main stream of the gas (23),
• wherein the first subsection (31) comprises at least one second feed line (70) for introducing a C₁- to C₄-alkane-containing gas into the second reactor section (30), wherein the at least one second feed line (70) is arranged such that the C₁- to C₄-alkane-containing gas which is introduced into the plasma reactor (120) via the at least one second feed line (70) is introduced into the plasmaeous gas at a position downstream of the foot points of the electric arc (21) in the flow direction of the main stream of the gas (23), so that in the first subsection (31) of the second reactor section (30) downstream of the at least one second feed line (70) a mixture is formed from the plasmaeous gas leaving the plasma section (20) and the C₁- to C₄-alkane-containing gas of the at least one second feed line (70), and wherein the position of the at least one second feed line (70) along the flow direction of the main stream of the gas (23) defines the beginning of the second reactor section (30) and of its first subsection (31), and
wherein the volume (22) of the plasma section (20) which begins at the most upstream position at which the inner surface of the hollow channel of the anode (50) is facing the electric arc (21) and reaches down to the end of the plasma section (20) of the plasma reactor (120) has a volume in the range of 0.0001 m³ to 0.4m³ and defines a reference volume, and
wherein the volume of the first subsection (31) of the second reactor section (30) is in the range of 10 to 200 times the reference volume and
wherein the volume of the total second reactor section (30) is in the range of 20 to 2,000 times the reference volume and
wherein the reactor comprises in the first subsection (31) of the second reactor section (30) and/or in the plasma section (20) in the range downstream in the flow direction of the main stream of the foot points of the electric arc on the inner surface of the hollow channel of the anode (50) down to the end of the plasma section (20) at least at one point a flow cross-section (71) transverse to the flow direction of the main stream which is greater by at least a factor of 5 in comparison with the average flow cross-section of the anode (50) transverse to the flow direction of the main stream in the range of the foot points of the electric arc (21) on the inner surface of the hollow channel of the anode (50).

2. Facility according to one of the preceding claims, wherein the reactor comprises in the first subsection (31) of the second reactor section (30) and/or in the plasma section (20) in the range downstream in the flow direction of the main stream of the foot points of the electric arc on the inner surface of the hollow channel of the anode (50) down to the end of the plasma section (20) at least at one point a flow cross-section (71) transverse to the flow direction of the main stream which is greater by at least a factor of 10 in comparison with the average flow cross-section of the anode (50) transverse to the flow direction of the main stream in the range of the foot points of the electric arc (21) on the inner surface of the hollow channel of the anode (50).

3. Facility according to claim 1, wherein the reference volume of the plasma reactor (120) is in the range of 0.001 to 0.2 m³, wherein the volume of the first subsection (31) of the second reactor section (30) is in the range of 20 to 100 times the reference volume, and wherein the volume of the total second reactor section (30) is in the range of 40 to 1,000 times the reference volume.

4. Facility according to one of the preceding claims, wherein the power plant unit (200) is a power plant unit which is exclusively operated with fluid input streams,
preferably a gas-fired power plant including a combustor (210), a gas-fired steam turbine (220) and a generator (230), a gas-fired combined cycle power plant, a gas engine or a fuel cell.

5. Facility according to one of the preceding claims, wherein the power plant (200) has a carbon footprint from 0 to 500 g_{CO2}/kWh_{used}, more preferably from 0 to 450 g_{CO2}/kWh_{used}, even more preferably from 0 to 400 g_{CO2}/kWh_{used}, most preferably from 0 to 350 gco2/kWhused.

6. Facility according to one of the preceding claims, wherein the device (100) for the production of hydrogen and solid carbon further includes at least one of
• a device for enrichment of hydrogen (140);
• at least one heat exchanger (1200); and
• a storage tank (150) for at least temporarily storing hydrogen.

7. Facility according to one of the preceding claims, wherein the device (100) for the production of hydrogen and solid carbon further includes at least one of a first gas outlet (132) and a second gas outlet (152),
wherein the first gas outlet (132) and/or the second gas outlet (152) are connected to a fuel gas inlet (211) of the power plant unit (200), preferably with an intermediate compression stage (500).

8. Facility according to one of the preceding claims, wherein the facility further comprises means for powering the device (100) for the production of hydrogen and solid carbon with power from the external power grid (300), electrical power from said power plant unit (200) or a mix of the aforementioned power types,
wherein the means preferably comprise at least one of a grid connector (301) and a transformer.

9. Facility according to one of the preceding claims, wherein the at least one device (100) for the production of hydrogen and solid carbon the power plant unit (200) are located at different sites,
wherein a distance between the at least one device (100) for the production of hydrogen and solid carbon the power plant unit (200) is at least 5 km, more preferably at least 10 km, most preferably from 10 km to 200 km.

10. Facility according to one of the preceding claims, wherein the facility further comprises at least one controller (600), wherein one controller is configured to output a command which determines the operation state of the device (100) for the production of hydrogen and solid carbon and the power plant unit (200) depending on an information with respect to a power in an external power grid (300), wherein the controller is preferably configured to output
iv) a command to run the power plant unit (200) at a high load and to shut down the device (100) for the production of hydrogen and solid carbon according to a first mode, or
v) a command to run the device (100) for the production of hydrogen and solid carbon at a high load and to shut down the power plant unit (200) according to a second mode, or
vi) a command to run the device (100) for the production of hydrogen and solid carbon and the power plant unit (200) at high loads according to a third mode.

11. Method for operating the facility according to the preceding claims, wherein the at least one device (100) for the production of hydrogen and solid carbon and the power plant unit (200) are run in such a way that the sum of full load hours of the respective plants is not more than 15,000 full load hours per year.

12. Method according to claim 11, wherein the at least one device (100) for the production of hydrogen and solid carbon and the power plant unit (200) are run not more than 14,000 full load hours per year, more preferably not more than 13,000 full load hours per year, even more preferably not more than 12,000 full load hours per year.

13. Method according to one of claims 11 and 12, wherein the power plant unit (200) is run
for at least 250 full load hours per year during times at which the at least one device (100) for the production of hydrogen and solid carbon runs at not more than 50 % of its design capacity, in particular at 0 % of its design capacity,
preferably for at least 500 full load hours per year during times at which the at least one device (100) for the production of hydrogen and solid carbon runs at not more than 50 %, of its design capacity, in particular at 0 % of its design capacity,
more preferably for at least 750 full load hours per year during times at which the at least one device (100) for the production of hydrogen and solid carbon runs at not more than 50 % of its design capacity, in particular at 0 % of its design capacity,
even more preferably for at least 1,000 full load hours per year during times at which the at least one device (100) for the production of hydrogen and solid carbon runs at not more than 50 % of its design capacity, in particular at 0 % of its design capacity,
most preferably for at least 1,500 full load hours per year during times at which the at least one device (100) for the production of hydrogen and solid carbon runs at not more than 50 % of its design capacity, in particular at 0 % of its design capacity.

14. Method according to one of claims 11 and 12, wherein the at least one device (100) for the production of hydrogen and solid carbon is run
for at least 250 full load hours per year during times at which the power plant unit (200) runs at not more than 50 % of its design capacity, in particular at 0 % of its design capacity,
preferably for at least 500 full load hours per year during times at which the power plant unit (200) runs at not more than 50 % of its design capacity, in particular at 0 % of its design capacity,
more preferably for at least 1,000 full load hours per year during times at which the power plant unit (200) runs at not more than 50 % of its design capacity, in particular at 0 % of its design capacity,
even more preferably for at least 1,500 full load hours per year during times at which the power plant unit (200) runs at not more than 50 % of its design capacity, in particular at 0 % of its design capacity,
most preferably for at least 2,000 full load hours per year during times at which the at least one device (100) for the production of hydrogen and solid carbon runs at not more than 50 % of its design capacity, in particular at 0 % of its design capacity.

15. Method according to one of claims 11 to 14, wherein a controller (600) of the facility receives a value corresponding to an information with respect to the power in the external power grid (300) as an input and,
iv) according to a first mode, outputs a command for running the power plant unit (200) at a high load and for shutting down the device (100) for the production of hydrogen and solid carbon; or
v) according to a second mode, outputs a command for running the device (100) for the production of hydrogen and solid carbon at a high load and for shutting down the power plant unit (200); or
vi) according to a third mode, outputs a command for running the device (100) for the production of hydrogen and solid carbon and the power plant unit (200) at high loads,
wherein the controller (600) preferably operates
according to mode iii), if the value is within a predefined tolerance range relative to a reference value,
according to mode i) or mode ii), if the value is above or below the tolerance range relative to the reference value.
